# EUROPEAN PATENT APPLICATION

(11) **EP 2 975 648 A1**
(43) Date of publication of application: **20.01.2016**
(21) Application number: 13878007.7
(22) Date of filing: 15.03.2013
(51) Int. Cl.: H01L 29/78, H01L 21/336

(54) **SEMICONDUCTOR DEVICE, AND MANUFACTURING METHOD FOR SAME**

(71) Applicant: TOYOTA JIDOSHA KABUSHIKI KAISHA, Toyota-shi, Aichi 471-8571 (JP)
(72) Inventor: IWASAKI Shinya, Toyota-shi Aichi 471-8571 (JP)
(74) Representative: TBK
(86) International application number: PCT/JP2013/057459
(87) International publication number: WO 2014/141472

(57) **Abstract**

Disclosed herein is a semiconductor device which includes a semiconductor substrate and a trench gate. The semiconductor substrate includes a first conductivity type drift layer, a second conductivity type body layer provided on a front surface side of the drift layer, and a first conductivity type first semiconductor layer provided on a part of a front surface of the body layer. The trench gate extends from a front surface of the semiconductor substrate through the body layer and the first semiconductor layer to reach the drift layer. The trench gate includes a gate insulating film formed on an inner wall of a trench, and a gate electrode disposed inside of the gate insulating film. The inner wall of the trench, which is located at a depth where the inner wall makes contact with the body layer of the semiconductor substrate, is a (100) crystal plane of the semiconductor substrate. A width of the trench in a transverse direction which is perpendicular to a longitudinal direction of the trench includes a width located at the front surface of the semiconductor substrate that is narrower than a width located at a depth from a lower end of the first semiconductor layer to a lower end of the body layer of the semiconductor substrate.

## Description

### TECHNICAL FIELD

A technology disclosed herein relates to a semiconductor device and a method for manufacturing the same.

### BACKGROUND ART

Generally, in a trench gate type semiconductor device, a trench gate is formed by: forming a trench by etching, the trench extending from a front surface of a semiconductor substrate to a position deeper than a boundary between a body layer and a drift layer; forming a gate insulating film on an inner wall of the trench; and then filling a gate electrode. Further, the body layer can be formed by implanting ions into a front surface side of the semiconductor substrate. In a process for manufacturing the trench gate type semiconductor device, an order in which the forming of the trench gate and the forming of the body layer are executed can be reversed as appropriate (see Japanese Patent Application Publication No. 2010-103326).

### SUMMARY OF INVENTION

### TECHNICAL PROBLEM

If the forming of the body layer is executed first, impurities in a portion of the semiconductor substrate located near a gate oxide film are absorbed when forming the gate oxide film. This causes variations in concentration of impurities in the portion of the semiconductor substrate located near the gate oxide film, thus causing variations in threshold voltage. On the other hand, if the forming of the trench gate is executed first, a step is formed due to a difference in height between a front surface of the semiconductor substrate and a front surface of the gate electrode in the subsequent forming of the body layer. Implanting ions, starting from this state, into the front surface of the semiconductor substrate causes variations in an implantation depth of the ions in the portion of the semiconductor substrate located near the gate oxide film located on a trench lateral surface, thus causing variations in the threshold voltage of the semiconductor device.

The present description provides a semiconductor device which makes it possible to suppress variations in threshold voltage which are caused by variations in concentration and an implantation depth of impurities, and a method for manufacturing such a semiconductor device.

### SOLUTION TO TECHNICAL PROBLEM

A semiconductor device disclosed in the present description comprises a semiconductor substrate and a trench gate. The semiconductor substrate comprises a first conductivity type drift layer, a second conductivity type body layer provided on a front surface side of the drift layer, and a first conductivity type first semiconductor layer provided on a part of a front surface of the body layer. The trench gate extends from a front surface of the semiconductor substrate through the body layer and the first semiconductor layer to reach the drift layer. The trench gate comprises a gate insulating film formed on an inner wall of a trench, and a gate electrode disposed inside of the gate insulating film. The inner wall of the trench, which is located at a depth where the inner wall makes contact with the body layer of the semiconductor substrate, is a (100) crystal plane of the semiconductor substrate. A width of the trench in a transverse direction which is perpendicular to a longitudinal direction of the trench includes a width located at the front surface of the semiconductor substrate that is narrower than a width located at a depth from a lower end of the first semiconductor layer to a lower end of the body layer of the semiconductor substrate.

In the semiconductor device described above, the width of the trench in the transverse direction which is perpendicular to the longitudinal direction of the trench includes the width located at the front surface of the semiconductor substrate that is narrower than the width located at the depth from the lower end of the first semiconductor layer to the lower end of the body layer of the semiconductor substrate. For this reason, at a position located at the depth from the lower end of the first semiconductor layer to the lower end of the body layer of the semiconductor substrate, a position at which a step is formed due to a difference in height between the front surface of the semiconductor substrate and a front surface of the gate electrode becomes closer to a center side of the trench in the transverse direction and becomes farther away from a gate oxide film located on a lateral surface of the trench. As a result, in a case where the forming of the trench gate is executed first and then the forming of the body layer is executed, variations in an implantation depth of ions in a portion of the semiconductor substrate located near the gate oxide film located on the lateral surface of the trench can be prevented. Furthermore, in the semiconductor device described above, the inner wall of the trench, which is located at the depth where the inner wall makes contact with the body layer of the semiconductor substrate, is the (100) crystal plane of the semiconductor substrate. For this reason, a level density at an interface between the gate oxide film and the semiconductor substrate is low, and variations in concentration of impurity ions are suppressed. The semiconductor device described above makes it possible to suppress variations in threshold voltage which are caused by variations in concentration and an implantation depth of impurities.

The present description discloses a method for manufacturing a semiconductor device which comprises a semiconductor substrate and a trench gate, where the semiconductor substrate comprises a first conductivity type drift layer, a second conductivity type body layer provided on a front surface side of the drift layer, and a first conductivity type first semiconductor layer provided on a part of a front surface of the body layer, and the trench gate extends from a front surface of the semiconductor substrate through the body layer and the first semiconductor layer to reach the drift layer. The method for manufacturing the semiconductor device may comprise forming the trench gate and forming the body layer. The forming of the trench gate may comprise forming a trench on a semiconductor wafer which includes the drift layer such that a width of the trench in a transverse direction which is perpendicular to a longitudinal direction of the trench is narrower at an opening portion located at the front surface of the semiconductor substrate than at a position located at a depth from a lower end of the first semiconductor layer to a lower end of the body layer of the semiconductor device, forming a gate insulating film on an inner wall of the trench, filling, inside the trench, a gate electrode which makes contact with the gate insulating film, forming a removed portion by removing at least a part of the gate electrode positioned below the opening portion of the trench, and filling the gate electrode inside the removed portion. The body layer may be formed by implanting second conductivity type ions into the semiconductor wafer after the gate electrode has been filled.

### BRIEF DESCRIPTION OF DRAWINGS

FIG. 1 is a plan view of a semiconductor device according to Embodiment 1;
FIG. 2 is a cross-sectional view taken along a line II-II of FIG. 1;
FIG. 3 is a cross-sectional view taken along a line III-III of FIG. 1;
FIG. 4 is a diagram showing a process for manufacturing a semiconductor device according to Embodiment 1;
FIG. 5 is a diagram showing a process for manufacturing a semiconductor device according to Embodiment 1;
FIG. 6 is a diagram showing a process for manufacturing a semiconductor device according to Embodiment 1;
FIG. 7 is a diagram showing a process for manufacturing a semiconductor device according to Embodiment 1;
FIG. 8 is a diagram showing a process for manufacturing a semiconductor device according to Embodiment 1;
FIG. 9 is a diagram showing a process for manufacturing a semiconductor device according to Embodiment 1;
FIG. 10 is a diagram showing a process for manufacturing a semiconductor device according to Embodiment 1;
FIG. 11 is a diagram showing a process for manufacturing a semiconductor device according to Embodiment 1;
FIG. 12 is a diagram showing a process for manufacturing a semiconductor device according to Embodiment 1;
FIG. 13 is a diagram showing a process for manufacturing a semiconductor device according to Embodiment 1;
FIG. 14 is a diagram showing a process for manufacturing a semiconductor device according to Embodiment 1;
FIG. 15 is a diagram showing a process for manufacturing a semiconductor device according to Embodiment 1;
FIG. 16 is a diagram showing a process for manufacturing a semiconductor device according to Embodiment 1;
FIG. 17 is a diagram showing a process for manufacturing a semiconductor device according to a modification example; and
FIG. 18 is a diagram showing a process for manufacturing a conventional semiconductor device.

### DESCRIPTION OF EMBODIMENTS

A semiconductor device disclosed herein is a trench gate type semiconductor device, and comprises a semiconductor substrate and a trench gate. The semiconductor substrate comprises a first conductivity type drift layer, a second conductivity type body layer provided on a front surface side of the drift layer, and a first conductivity type first semiconductor layer provided on a part of a front surface of the body layer. The trench gate extends from a front surface of the semiconductor substrate through the body layer and the first semiconductor layer to reach the drift layer. Specific examples of the semiconductor device disclosed herein include, but are not limited to, an IGBT, a MOSFET, and the like. In the IGBT, the first semiconductor layer is an emitter layer. In the MOSFET, the first semiconductor layer is a source layer.

### Embodiment 1

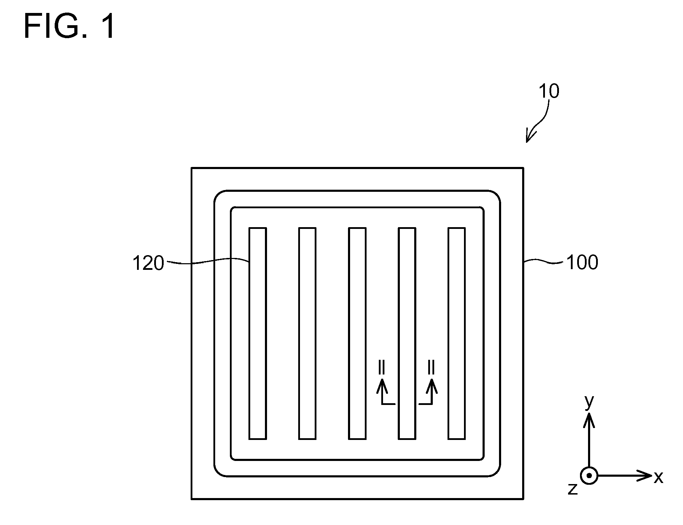

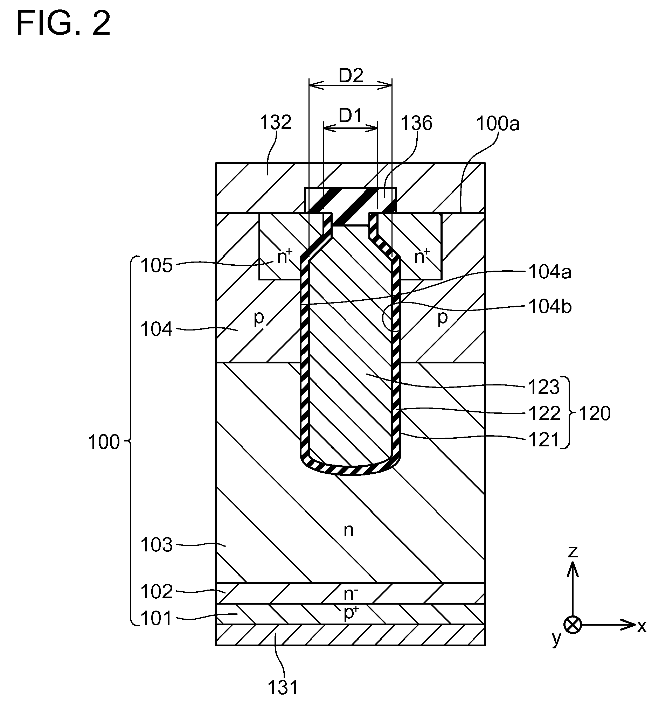

FIGS. 1 and 2 show a semiconductor device 10 according to Embodiment 1. The semiconductor device 10 comprises a semiconductor substrate 100, a plurality of trench gates 120 formed on a front surface side of the semiconductor substrate 100 (a side toward a positive direction of a z axis), a back surface electrode 131 which is in contact with a back surface of the semiconductor substrate 100, and a front surface electrode 132 which is in contact with a front surface of the semiconductor substrate 100. A longitudinal direction of each of the trench gates 120 is a y direction, and a transverse direction which is perpendicular to the longitudinal direction is an x direction. The plurality of trench gates 120 is placed at intervals in the x direction.

In the semiconductor substrate 100, a vertical IGBT is formed. As shown in FIGS. 1 and 2, the semiconductor substrate 100 comprises a p⁺-type collector layer 101, an n⁻-type buffer layer 102, an n-type drift layer 103, a p-type body layer 104, and n⁺-type emitter layers 105. The body layer 104 is in contact with a front surface of the drift layer 103, and a part of the body layer 104 is exposed on the front surface of the semiconductor substrate 100. The emitter layers 105 are provided on parts of a front surface of the body layer 104, exposed on the front surface of the semiconductor substrate 100, and separated from the drift layer 103 by the body layer 104. The buffer layer 102 is provided on a back surface of the drift layer 103. The collector layer 101 is in contact with a back surface of the buffer layer 102 and is exposed on the back surface of the semiconductor substrate 100. The emitter layers 105 and the body layer 104 are in contact with the front surface electrode 132, and the collector layer 101 is in contact with the back surface electrode 131.

Each of the trench gates 120 comprises a trench 121 which extends from the front surface of the semiconductor substrate 100 through the body layer 104 to reach the drift layer 103, a gate insulating layer 122 formed on an inner wall surface of the trench 121, and a gate electrode 123 covered with the gate insulating film 122 and filled inside the trench 121. An insulating film 136 is provided between the gate electrode 123 and the front surface electrode 132. The gate electrode 123 and the front surface electrode 132 are insulated from each other by the insulating film 136. The trench gate 120 is in contact with the corresponding emitter layer 105 at a portion of the semiconductor substrate 100 located near the front surface of the semiconductor substrate 100, is in contact with the body layer 104 at a side of the semiconductor substrate 100 deeper than the emitter layer 105 (a side toward a negative direction of the z axis), and is in contact with the drift layer 103 at a side of the semiconductor substrate 100 deeper than the body layer 104. Inner walls 104a and 104b of the trench 121 which are located at a depth where the inner walls make contact with the body layer 104 are (100) crystal planes of the semiconductor substrate. The inner walls 104a and 104b are orthogonal to the x direction, face each other, and are substantially perpendicular to the front surface 104a of the semiconductor substrate 100. A width of the trench 121 in the x direction is D1 at a position located on the front surface side of the semiconductor substrate 100 and D2 at a position located at a depth from a lower end of the emitter layer 105 to a lower end of the body layer 104, and D1<D2. The width of the trench 121 in the x direction becomes gradually narrower substantially in a linear fashion as it extends from an upper end of a portion of the trench 121 whose width is D2 toward a lower end of a portion of the trench 121 whose width is D1. At a position located on the front surface of the semiconductor substrate 100, as compared with the position located at the depth from the lower end of the emitter layer 105 to the lower end of the body layer 104, the semiconductor substrate 100 is in such a state as to protrude toward a center of the trench 121 in the x direction.

As stated above, in the semiconductor device 10, a width of the trench 121 in the transverse direction which is perpendicular to the longitudinal direction of the trench 121 includes the width (D1) located at the front surface of the semiconductor substrate 100 that is narrower than the width (D2) located at the depth from the lower end of the emitter layer 105 to the lower end of the body layer 104 of the semiconductor substrate 100. For this reason, at a position located on the front surface of the semiconductor substrate 100, as compared with the position located at the depth from the lower end of the emitter layer 105 to the lower end of the body layer 104, the semiconductor substrate 100 is in such a state as to protrude toward the center of the trench 121 in the x direction. As a result, a position at which a step is formed due to a difference in height between the front surface of the semiconductor substrate 100 and a front surface of the gate electrode 123 becomes closer to a center side of the trench 121 in the transverse direction (x direction) than has conventionally been the case and, at the position located at the depth from the lower end of the emitter layer 105 to the lower end of the body layer 104, becomes farther away from the gate oxide film 122 located on a lateral surface of the trench 121. With this, as will be mentioned later, in a case where forming the trench gate 120 is executed first and then forming the body layer 104 is executed, variations in an implantation depth of ions in a portion of the semiconductor substrate 100 located near the gate oxide film 122 located on the lateral surface of the trench 121 can be prevented. The semiconductor device 10 described above makes it possible to suppress variations in threshold voltage which are caused by variations in concentration and the implantation depth of impurities. Further, in the semiconductor device 10, the inner walls 104a and 104b of the trench 121, which are located at the depth where the inner walls make contact with the body layer 104, are (100) crystal planes of the semiconductor substrate 100. For this reason, as compared with a case where other crystal planes are used, a level density at an interface between the gate oxide film 122 and the semiconductor substrate 100 is low, and variations in concentration of impurity ions are suppressed.

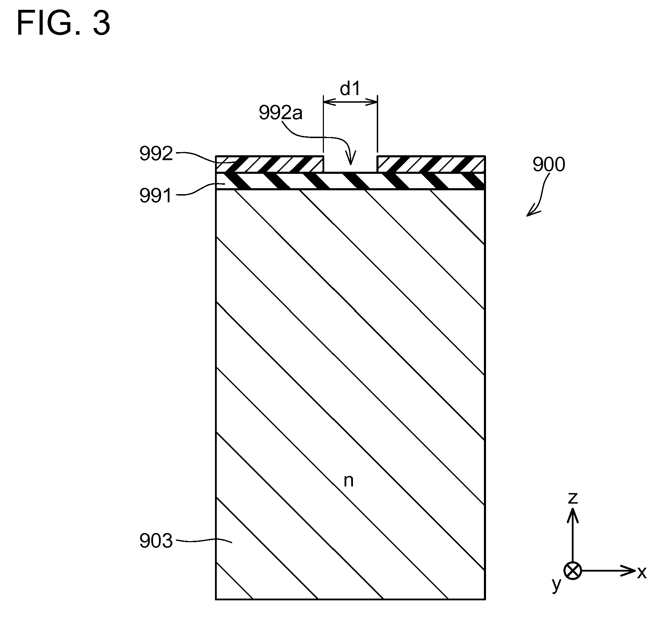

An example of a method for manufacturing the semiconductor device 10 is described below with reference to FIGS. 3 to 16. First, as shown in FIG. 3, a semiconductor wafer 900 is prepared. The semiconductor wafer 900 comprises an n layer 903 (which is to serve as the drift layer 103). Next, an oxide film mask 991 is formed on a front surface of the semiconductor wafer 900, and a resist 992 is further formed on a front surface of the oxide film mask 991. The resist 992 has an opening portion 992a in which the trench 121 is formed. A width d1 of the opening portion 992a in the x direction is substantially equal to the width D1 of the trench 121, and a length of the opening portion 992a in the y direction is substantially equal to a length of the trench 121 in the y direction.

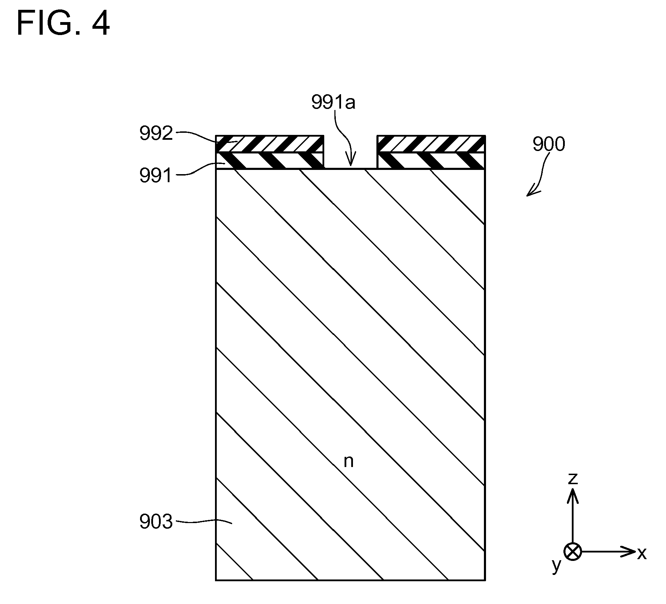

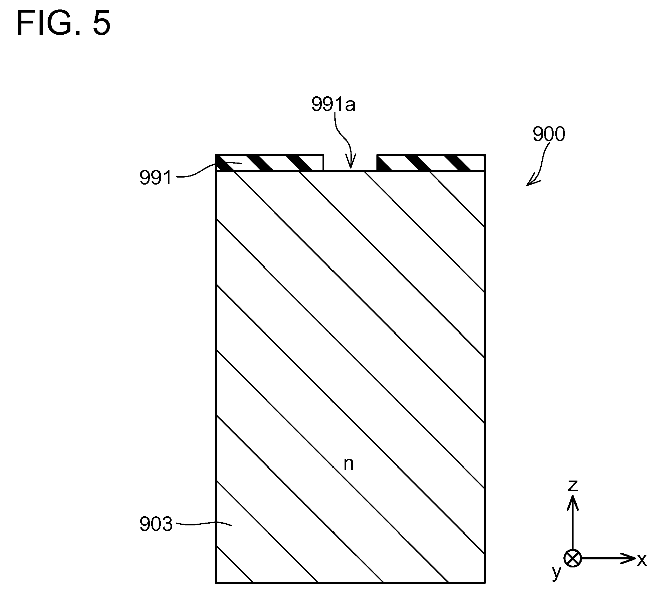

Next, as shown in FIG. 4, an opening portion 991a is formed in the mask 991 by performing dry etching. A shape and a size of the opening portion 991a are substantially identical to those of the opening portion 992a. Furthermore, as shown in FIG. 5, the resist 992 is removed.

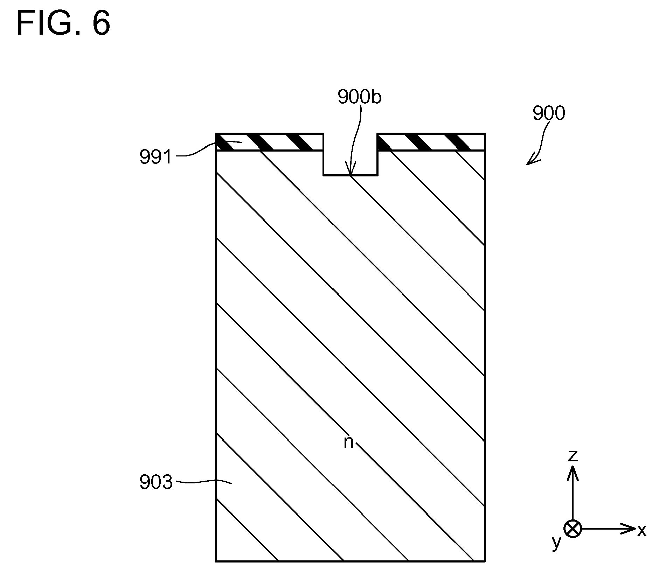

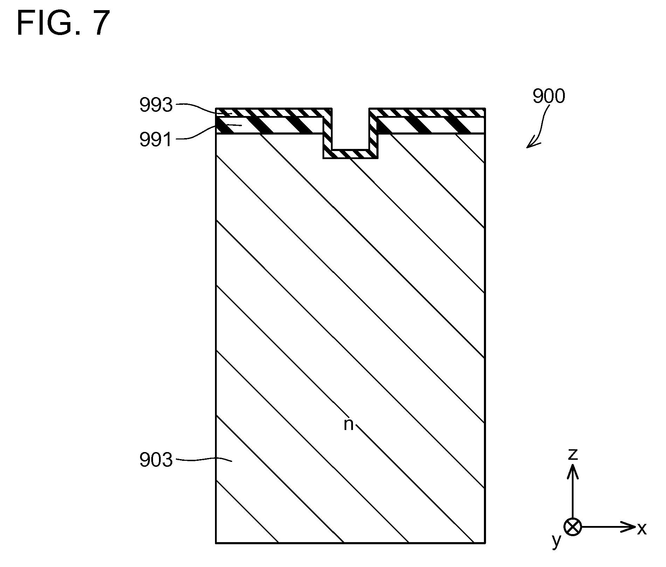

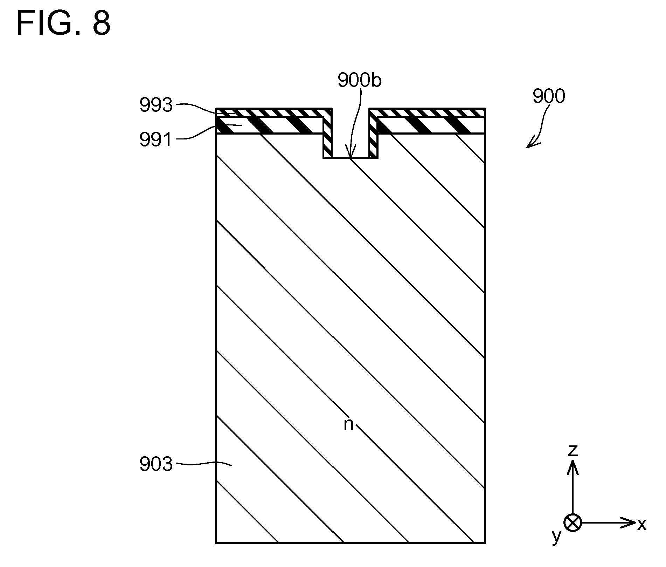

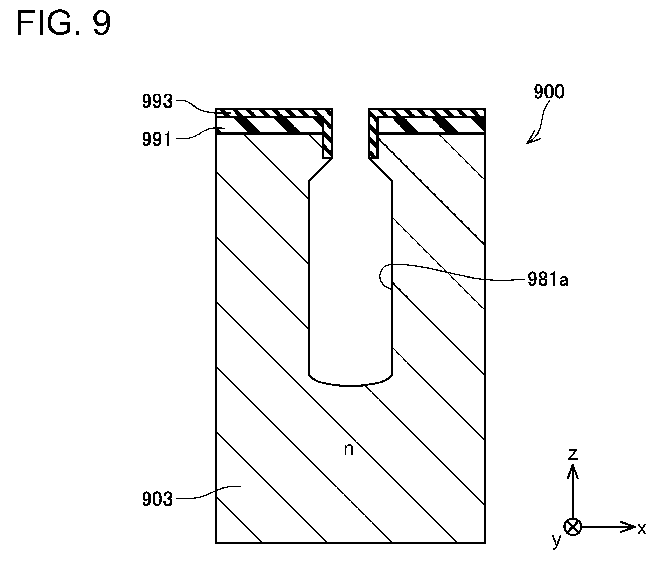

In a state shown in FIG. 5, the semiconductor wafer 900 is etched, whereby, as shown in FIG. 6, a shallow trench 900b is formed. A width of the trench 900b is substantially equal to a width of the opening portion 991a. A depth of the trench 900b is set to correspond to a depth of a lower end of a portion of the trench 121 whose depth in the x direction is D1 in FIG. 2. Next, as shown in FIG. 7, an oxide film 993 is formed on the front surface of the semiconductor wafer 900. Furthermore, as shown in FIG. 8, a bottom part of the trench 900b is exposed by removing a portion of the oxide film 993 covering the bottom part of the trench 900b. In a state shown in FIG. 8, isotropic dry etching is performed on the semiconductor wafer 900, whereby, as shown in FIG. 9, a trench 981a is formed. A portion of the semiconductor wafer 900 located near the front surface of the semiconductor wafer 900 is covered with the oxide film 993 and therefore is not etched in the forming of the trench 981 a, with a result that a width of the trench 900b is maintained. A width of the trench 981 a in the x direction becomes greater as it becomes deeper in a depth direction of the semiconductor wafer 900 (the negative direction of the z axis) from a lower end of the oxide film 993 to a predetermined depth and, at a deeper position, is a substantially constant width which is substantially equal to the width D2 of the trench 121.

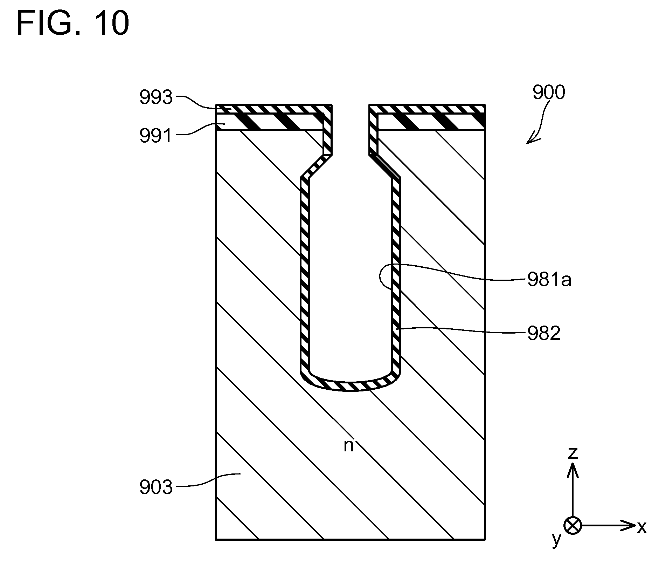

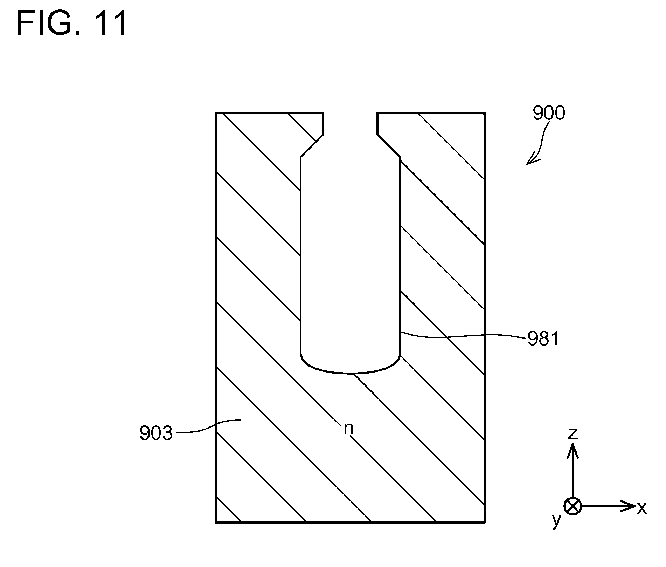

Next, a process for repairing damage done to the semiconductor wafer 900 in the forming of the trench 981 a is performed. This process causes an oxide film 982 to be formed on an inner wall of the trench 981a as shown in FIG. 10. Next, as shown in FIG. 11, the oxide films 991 and 982 are removed by etching. This causes a trench 981 to be formed. A shape and a size of the trench 981 are substantially identical to those of the trench 121.

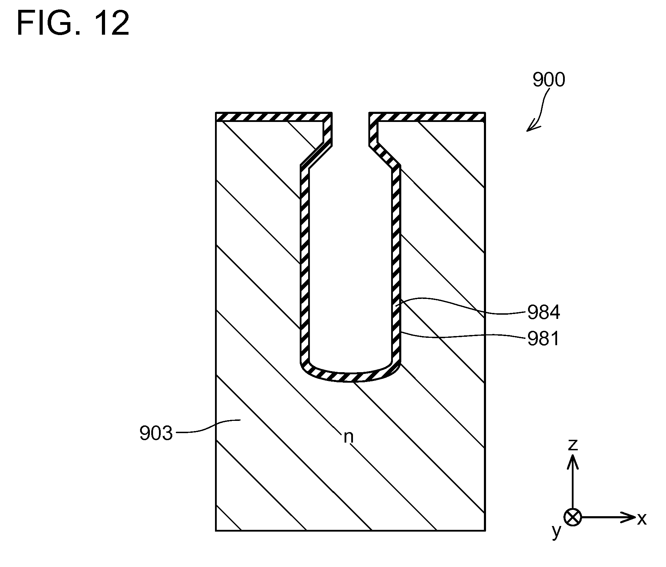

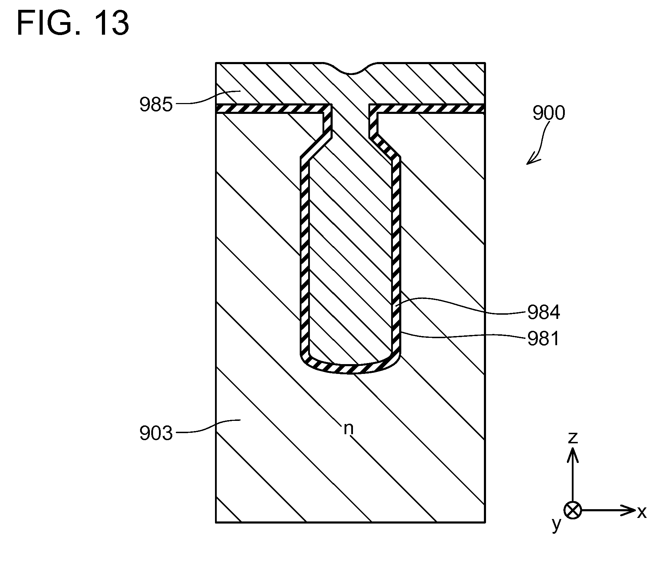

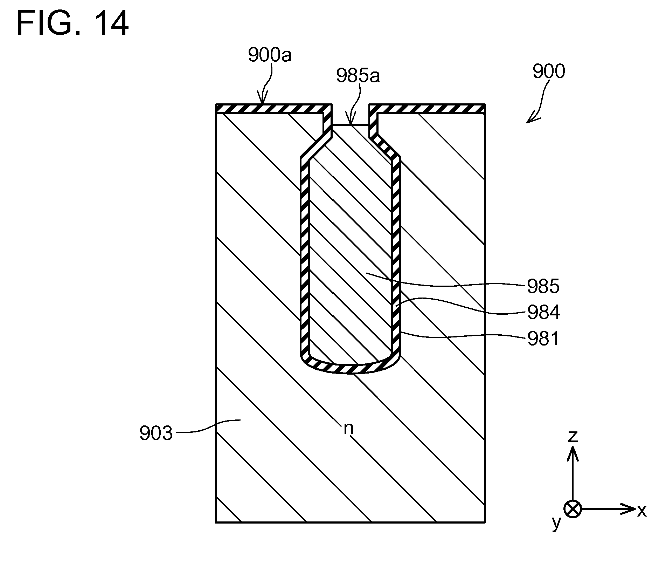

Next, as shown in FIG. 12, an oxide film 984 is formed on the front surface of the semiconductor wafer 900 and in the trench 981. As a method for forming the oxide film 984, a conventional method of forming such as a dry oxidation method, a wet oxidation method, or a CVD method can be employed. A part of the oxide film 984 is to serve as the gate insulating film 122. Next, as shown in FIG. 13, a polysilicon 985 is filled inside the trench 981. As a method for forming the polysilicon 985, a conventional method of forming such as a PVD method or a CVD method can be employed. In so doing, the polysilicon 985 is also deposited on the front surface of the semiconductor wafer 900. Therefore, as shown in FIG. 14, the polysilicon 985 is removed, excluding a portion of the polysilicon 985 which is to serve as the gate electrode 123. A front surface 985a of the polysilicon 985 is depressed with respect to the front surface 900a of the semiconductor wafer 900.

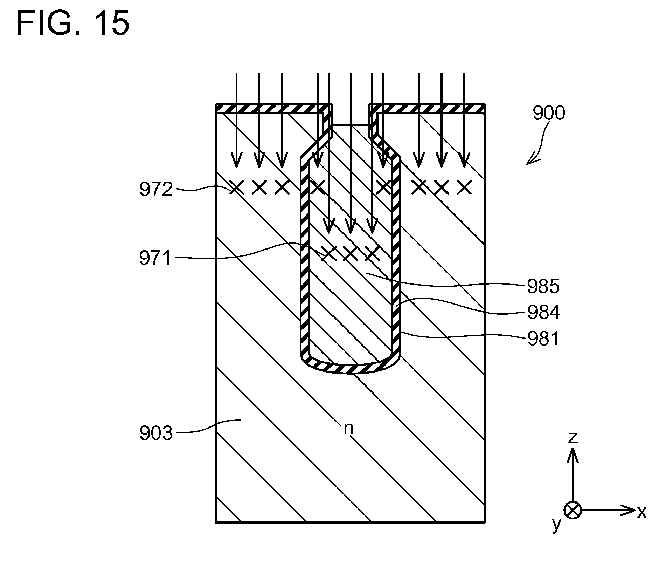

Next, in order for the body layer 104 to be formed, p-type impurity ions are implanted into the semiconductor wafer 900 shown in FIG. 14 from a front surface side of the semiconductor wafer 900. Since the front surface 985a is depressed with respect to the front surface 900a, as shown in FIG. 15, ions 971 applied to a position located below the front surface 985a are implanted into a deeper position in the semiconductor wafer 900 than are ions 972 applied to a position located below the front surface 900a. Since the front surface 900a protrudes toward a center of the trench 981 in the x direction, there is a difference in implantation location between the ions 971 and the ions 972 within the polysilicon 985. In other words, a region where there is a difference in implantation location between the ions 971 and the ions 972 is off a lateral wall of the trench 981 and the oxide film 984 toward the center of the trench 981 in the x direction.

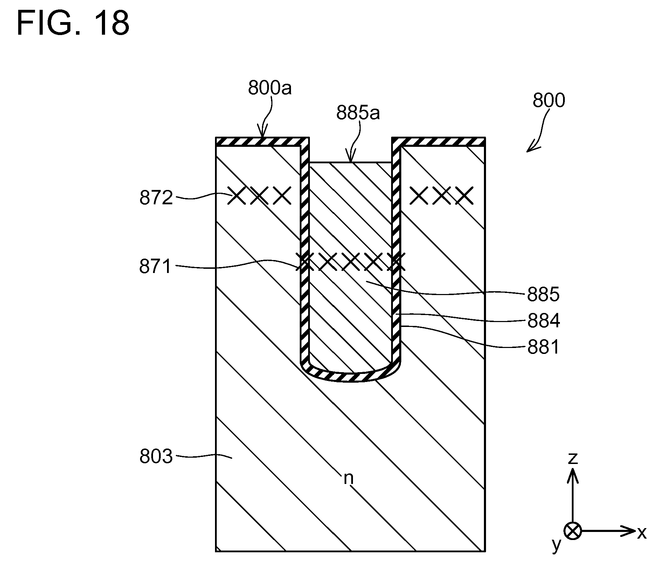

FIG. 18 relates to a process for manufacturing a semiconductor device having a conventional trench shape. As with FIG. 15, FIG. 18 is a diagram explaining a process of implanting p-type ions in order to form a body layer. As with the semiconductor wafer 900, a semiconductor wafer 800 comprises an n layer 803. A trench 881 is formed in the semiconductor wafer 800. A width of the trench 881 in the x direction is substantially constant in a depth direction of the semiconductor wafer 800. An oxide film 884 is formed on an inner wall of the trench 881 and the like, and a polysilicon 885 is filled inside the trench 881. A part of the oxide film 884 is to serve as a gate insulating film, and the polysilicon 885 is to serve as a gate electrode. In order for the body layer to be formed, p-type impurity ions are implanted into the semiconductor wafer 800 from a front surface side of the semiconductor wafer 800. A front surface 885a of the polysilicon 885 is depressed with respect to a front surface 800a of the semiconductor wafer 800. Therefore, as shown in FIG. 18, ions 871 applied to a position located below the front surface 885a are implanted into a deeper position in the semiconductor wafer 800 than are ions 872 applied to a position located below the front surface 800a. As a result, a boundary between the ions 871 and the ions 872 is located near a lateral wall of the trench 881 (inner wall which is substantially perpendicular to the x axis). Consequently, variations in implantation depth are likely to occur in a portion of the semiconductor wafer 800 located near the trench 881.

In contrast, in the process for manufacturing the semiconductor device 10, the region where there is a difference in implantation location between the ions 971 and the ions 972 is off the lateral wall of the trench 981 and the oxide film 984 toward the center of the trench 981 in the x direction. This makes it possible to prevent variations in implantation depth of ions in a portion of the semiconductor wafer 900 located near the oxide film 984 located on the lateral surface of the trench 981.

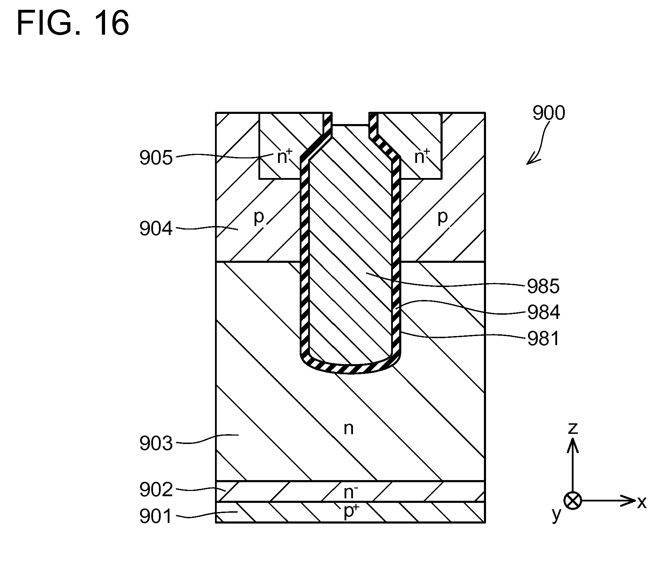

Next, in order for the emitter layer 105 to be formed, n-type ions are implemented into the front surface side of the semiconductor wafer 900, and in order for the buffer layer 102 and the collector layer 101 to be formed, n-type and p-type ions are implanted into a back surface side of the semiconductor wafer 900. Then, an annealing process is performed. With this, as shown in FIG. 16, a p layer 904 (which is to serve as the body layer 104) and an n⁺ layer 905 are formed on the front surface side of the semiconductor wafer 900, and a p⁺ layer 901 (which is to serve as the collector layer 101) and an n layer 902 (which is to serves as the buffer layer 102) are formed on the back surface side of the semiconductor wafer 900. Furthermore, a portion of the oxide film 984 located on the front surface of the semiconductor wafer 900 is removed. Furthermore, by forming the back surface electrode 131, the front surface electrode 132, and the like using a conventionally publicly known manufacturing method, the semiconductor device 10 shown in FIG. 1 can be manufactured.

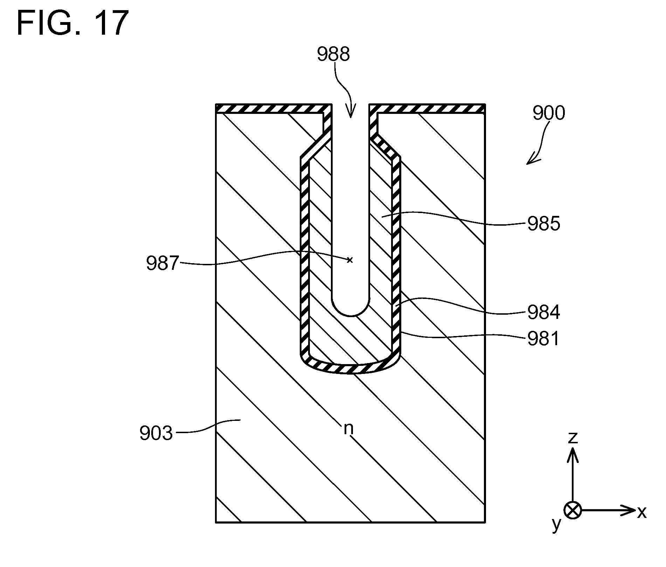

It should be noted that the following steps may be added to more surely fill the polysilicon 985 inside the trench 981. First, an etching process is performed on the polysilicon 985 in a state shown in FIG. 13, and as shown in FIG. 17, a removed portion 987 is formed by removing a portion of the polysilicon 985 located on the front surface of the semiconductor wafer 900 and at least a part of the polysilicon 985 positioned below an opening portion 988 of the trench 981. Furthermore, the forming of a polysilicon 985 is executed again to fill the polysilicon 985 into the removed portion 987. This makes it possible to more surely fill the polysilicon 985 inside the trench 981 whose opening portion 988 is narrower than a bottom side of the trench 981.

Specific examples of the present invention have been described in detail, however, these are mere exemplary indications and thus do not limit the scope of the claims. The art described in the claims includes modifications and variations of the specific examples presented above.

Technical features described in the description and the drawings may technically be useful alone or in various combinations, and are not limited to the combinations as originally claimed. Further, the art described in the description and the drawings may concurrently achieve a plurality of aims, and technical significance thereof resides in achieving any one of such aims.

## Claims

1. A semiconductor device comprising:
a semiconductor substrate which comprises:
a first conductivity type drift layer;
a second conductivity type body layer provided on a front surface side of the drift layer; and
a first conductivity type first semiconductor layer provided on a part of a front surface of the body layer; and
a trench gate extending from a front surface of the semiconductor substrate through the body layer and the first semiconductor layer to reach the drift layer, wherein
the trench gate comprises a gate insulating film formed on an inner wall of a trench, and a gate electrode disposed inside of the gate insulating film,
the inner wall of the trench, which is located at a depth where the inner wall makes contact with the body layer of the semiconductor substrate, is a (100) crystal plane of the semiconductor substrate, and
a width of the trench in a transverse direction which is perpendicular to a longitudinal direction of the trench includes a width located at the front surface of the semiconductor substrate that is narrower than a width located at a depth from a lower end of the first semiconductor layer to a lower end of the body layer of the semiconductor substrate.

2. A method for manufacturing a semiconductor device which comprises:
a semiconductor substrate which comprises:
a first conductivity type drift layer;
a second conductivity type body layer provided on a front surface side of the drift layer; and
a first conductivity type first semiconductor layer provided on a part of a front surface of the body layer; and
a trench gate extending from a front surface of the semiconductor substrate through the body layer and the first semiconductor layer to reach the drift layer,
the method comprising:
forming the trench gate; and
forming the body layer, wherein
the forming of the trench gate comprises:
forming a trench on a semiconductor wafer which includes the drift layer such that a width of the trench in a transverse direction which is perpendicular to a longitudinal direction of the trench is narrower at an opening portion located at the front surface of the semiconductor substrate than at a position located at a depth from a lower end of the first semiconductor layer to a lower end of the body layer of the semiconductor device;
forming a gate insulating film on an inner wall of the trench;
filling, inside the trench, a gate electrode which makes contact with the gate insulating film;
forming a removed portion by removing at least a part of the gate electrode positioned below the opening portion of the trench; and
filling the gate electrode inside the removed portion, and
the body layer is formed by implanting second conductivity type ions into the semiconductor wafer after the gate electrode has been filled.
